(11) **EP 1 355 431 B1**

(12) **EUROPEAN PATENT SPECIFICATION**

(45) Date of publication and mention
of the grant of the patent:
**08.03.2006 Bulletin 2006/10**

(21) Application number: **01273082.6**

(22) Date of filing: **05.12.2001**

(51) Int Cl.:
*H03M 13/41* (2006.01)   *H04L 1/00* (2006.01)

(86) International application number:
**PCT/JP2001/010624**

(87) International publication number:
**WO 2002/056480 (18.07.2002 Gazette 2002/29)**

(54) **Viterbi decoding processor**

Prozessor zur Viterbi-Decodierung

Processeur de décodage de Viterbi

(84) Designated Contracting States:
**DE GB NL**

(30) Priority: **15.01.2001 JP 2001006066**

(43) Date of publication of application:
**22.10.2003 Bulletin 2003/43**

(73) Proprietor: **NEC CORPORATION**
**Minato-ku,**
**Tokyo 108-8001 (JP)**

(72) Inventor: **IKEKAWA, Masao,**
**c/o NEC CORPORATION**
**Minato-ku, Tokyo 108-8001 (JP)**

(74) Representative: **Vossius & Partner**
**Siebertstrasse 4**
**81675 München (DE)**

(56) References cited:
**EP-A- 0 917 295        JP-A- 6 090 178**
**JP-A- 10 171 778       JP-A- 11 261 426**
**JP-A- 2000 222 174**

- **KUMURA T ET AL: "FAST VITERBI DECODING ON A GENERAL PURPOSE DSP WITH VITERBI INSTRUCTIONS" NEN DENSHI JOHO TSUSHIN GAKKAI KISO KYOUKAI SOCIETY TAIKAI KOEN RONBUNSHUU, vol. A-4-40, 9 March 2001 (2001-03-09), page 140, XP002908804**
- **TAKAHIRO KUMURA ET AL.: 'Viterbi senyou meirei wo sonaeta hanyou DSP ni yoru kousoku viterbi fukugou' DENSHI JOHO TSUUSHIN GAKKAI, 2001-NEN SOUGOU TAIKAI KOUEN RONBUNSHUU (KISO, KYOUKAI) (A-4-40) 09 March 2001, page 140, XP002908804**

**Description**

Background of the Invention

The present invention relates to a Viterbi decoding processor and, more particularly, to a Viterbi decoding processor which performs Viterbi decoding which realizes high-quality digital communication.

In digital radio communication, a combination of convolutional coding and Viterbi decoding has widely been used to suppress the influence of a bit error in the transmission channel and realize high-quality communication. Viterbi decoding is realized by a digital signal processor (to be referred to as a DSP hereinafter) incorporated in a communication device. Recent DSPs are required to have an architecture capable of efficiently realizing Viterbi decoding. Viterbi decoding efficiently executes maximum likelihood decoding by soft decision using the repetitive structure of a convolutional code. Viterbi decoding is achieved by repetition of a series of processes called ACS (Add Compare Select) processing and traceback operation of finally decoding data.

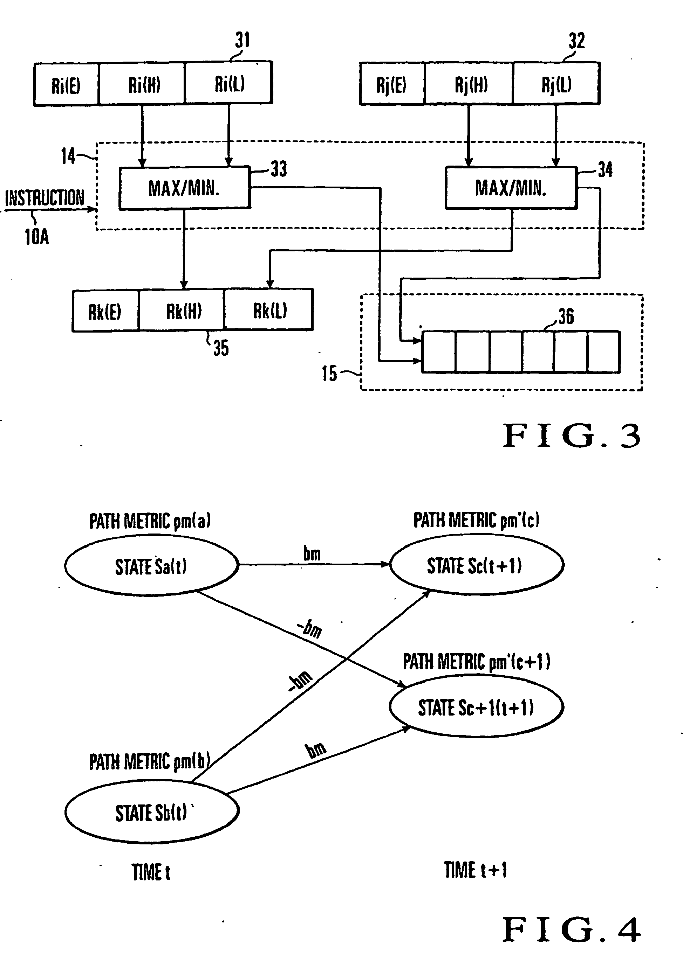

In Viterbi decoding, a surviving path, i.e. original coded data sequence closest to a reception data sequence is obtained by sequentially selecting surviving paths in respective states at new times every time a reception data sequence is obtained for one information bit in a trellis diagram showing the internal state and transition of an encoder with a convolutional code. At this time, the signal distance between the coded data sequence and the reception data sequence represented by each surviving path must be calculated as a surviving path selection criterion, and ACS processing is repetitively executed. To efficiently realize Viterbi decoding by the DSP, ACS processing must be efficiently executed. Fig. 4 is an explanatory view showing ACS processing.

In general, when the coding ratio and constraint length of an encoder are determined, states at respective times and branch patterns representing transition between them are expressed by simple repetition in a trellis diagram. At time t+1. attention is paid to two states adjacent to each other in the trellis diagram, i.e., two states Sc(t+1) and Sc+1 (t+1) whose coded data sequence (output symbol) values (binary numbers) corresponding to the respective states are adjacent to each other. Path metrics pm'(c) and pm'(c+1) of the states Sc(t+1) and Sc+1(t+1) are given by

$$\mathtt{pm'(c) \; = \; MAX(pm(a) \; + \; bm, \; pm(b) \; - \; bm)} \qquad \ldots(1)$$

$$\mathtt{pm'(c+1) \; = \; MAX(pm(a) \; - \; bm, \; pm(b) \; + \; bm)} \qquad \ldots(2)$$

where pm(a) and pm(b) are the path metric values of two states Sa(t) and Sb(t) which can be connected to the states Sc(t+1) and Sc+1(t+1), and bm and -bm are the Hamming distances, i.e.. branch metrics between paths corresponding to branches and reception data sequences that are associated with the branches for connecting the states, as shown in Fig. 4. In the present invention, a function of selecting a larger one of values x and y is expressed as MAX(x,y), and a function of selecting a smaller one of the values x and y is expressed as MIN(x,y). In the above equations, MIN may be adopted in place of MAX depending on the branch metric expression method.

To efficiently perform ACS processing, there has conventionally been proposed a DSP processor architecture in which a plurality of adders-subtracters and a plurality of comparators are arranged to enable parallel-executing ACS processing (see, e.g., Japanese Patent Laid-Open No. 11-261426 published as JP11261426 and EP9917295: reference 1, and Japanese Patent Laid-Open No. 11-74801 published as JP11074801 and US 5987490: reference 2).

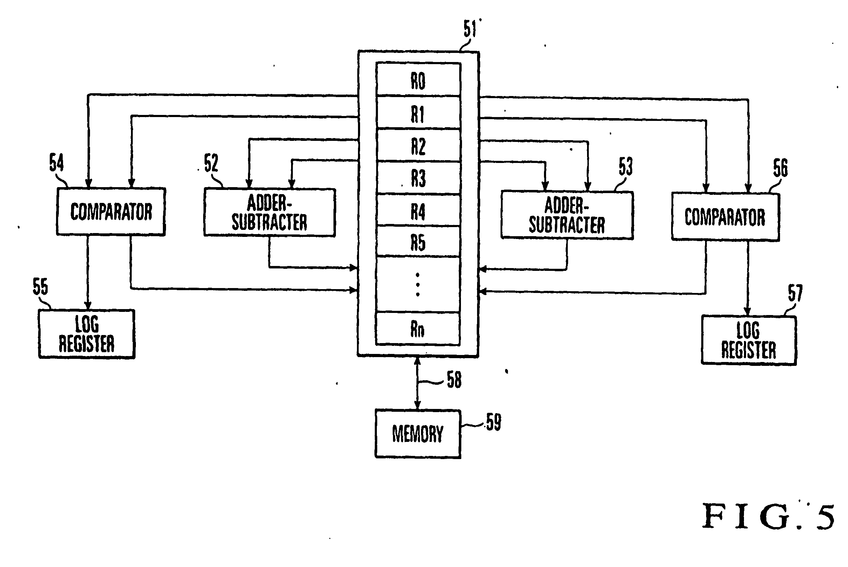

Fig. 5 is a block diagram showing a conventional Viterbi decoding processor in reference 1. In this case, operands (address information) and the values of arithmetic results input to adders-subtracters 52 and 53 are temporarily stored in any one of a plurality of registers in a register file 51.

Each of the adders-subtracters 52 and 53 adopt two registers Ri and Rj as input operands, and executes parallel addition-subtraction for upper-side Ri(H) and Rj(H) and lower-side Ri(L) and Rj(L). The sum and difference are respectively stored in the upper-side Rk(H) and lower-side Rk(L) of a register Rk.

Each of comparators 54 and 56 uses one register Ri as an operand, compares the magnitudes of the upper-side Ri(H) and lower-side Ri(L), and stores, e.g., a larger value in the register Rk. At the same time, the comparator stores a 1-bit comparison result in a corresponding one of log regisers 55 and 57.

In this Viterbi decoding processor, ACS processing for two states is executed by the following procedures. Branch metric values bm and -bm are read out from a memory 59, and respectively stored on the upper and lower sides of a register R0. Path metric values pm(a) and pm(b) are read out from the memory 59, and respectively stored on the upper and lower sides of a register R1. The adder-subtracter 52 performs parallel addition of the registers R0 and R1, stores a value pm(a)+bm on the upper side of a register R2, and stores a value pm(b)-bm on its lower side.

The adder-subtracter 53 performs parallel subtraction of the registers R0 and R1, stores a value pm(a)-bm on the upper side of a register R3, and stores a value pm(b)+bm on its lower side. The comparator 54 compares the upper and lower sides of the register R2, stores a larger value in a register R4, and at the same time stores one bit representing the comparison result in the log regiser 55. At this time, the value stored in R4 is equal to pm'(c) in equation (1). The bit stored in the log regiser 54 is used in processing called traceback.

The comparator 56 compares the upper and lower sides of the register R3, stores a larger value in a register R5, and at the same time stores one bit representing the comparison result in the log regiser 57. At this time, the value stored in the register R5 is equal to pm'(c+1) in equation (2). The contents of the registers R4 and R5 are stored in the memory 59. In reference 2, there is proposed an architecture of exchanging the operand and arithmetic result of an arithmetic unit directly with a memory. This architecture is different from an architecture using the above-mentioned register file. However, these architectures are essentially the same in a sense that two pairs of adders-subtracters and comparators are arranged to parallel-execute ACS processing.

In the conventional Viterbi decoding processor, it takes a long time to load data from the memory to the register file and store data from the register file to the memory. For example, to perform ACS processing for two states, data must be loaded four times in order to load two path metrics and two branch metrics into the register, and data must be stored two times in order to store two newly obtained path metrics in the memory. For efficient processing, the operation speed of the overall apparatus must be increased, resulting in a large processor scale and high power consumption.

Summary of the Invention

The present invention has been made to overcome the conventional drawbacks, and has as its object to provide a Viterbi decoding processor capable of efficiently performing ACS processing without increasing the operation speed or using complicated processing.

To achieve the above object, according to the present invention, there is provided a Viterbi decoding processor comprising a memory which stores with a 1-word width a path metric and a branch metric that appear in Viterbi decoding, a register file having a plurality of registers with at least a 2-word width which temporarily store 1-word width data on upper and lower sides, and arithmetic means for calculating a new path metric on the basis of a predetermined arithmetic expression using the path metric and the branch metric which are loaded from the memory to an arbitrary register of the register file via a bus, wherein the arithmetic means comprises a comparator which uses, of the registers, two predetermined registers as input operands, compares values on the upper and lower sides of a first register as one of the two registers, stores a value selected in accordance with a comparison result on the upper side of a third register out of the registers, compares values on the upper and lower sides of a second register as the other register, and stores a value selected in accordance with a comparison result on the lower side of the third register, a 2-word width data bus is used as the bus, and the register file simultaneously reads out 2-word width data stored on the upper and lower sides of the third register and stores the 2-word width data at adjacent addresses in the memory via the data bus.

In this case, a log register which simultaneously stores two bits representing comparison results of two comparison calculations executed by the comparator may be arranged in consideration of subsequent traceback processing. The comparator may select a larger or smaller value of the two values in accordance with a predetermined instruction in comparison calculation.

To efficiently perform addition-subtraction processing, the arithmetic means may further comprise a first adder-subtracter which uses, of the registers, two predetermined registers as input operands, parallel-executes first addition using a value on the upper side of a fourth register as one of the two registers and a value on the upper side of a fifth register as the other register and second addition using values on the lower sides of the fourth and fifth registers, stores a result of the first addition on the upper side of the first register and a result of the second addition on the lower side of the first register, and a second adder-subtracter which uses the fourth and fifth registers as input operands, parallel-executes first subtraction using the values on the upper sides of the fourth and fifth registers and second subtraction using the values on the lower sides of the fourth and fifth registers, stores a result of the first subtraction on the upper side of the second register and a result of the second subtraction on the lower side of the second register.

As for a branch metric used in ACS processing, the memory may store, at adjacent addresses, 1-word width branch metrics for two branches which change from two states at immediately preceding time to one state at time of interest in a trellis diagram, and the register file may simultaneously read out the two branch metrics stored in the memory via the data bus and load the two branch metrics to the upper and lower sides of the fifth register.

When data is to be exchanged between the memory and the register file, two 2-word width data buses may be arranged as the bus instead of the data bus, and the register file may parallel-execute, individually using the two data buses, two operations out of simultaneous load of the two branch metrics from the memory to the fifth register, individual load of each path metric from the memory to the fourth register, and simultaneous store of two new path metrics from the third register to the memory.

Brief Description of Drawings

Fig. 1 is a block diagram showing a Viterbi decoding processor according to an embodiment of the present invention;
Fig. 2 shows an arrangement of a register;
Fig. 3 is an explanatory view showing the operation of a comparator;
Fig. 4 is an explanatory view showing ACS processing; and
Fig. 5 is a block diagram showing a conventional Viterbi decoding processor.

Detailed Description of the Preferred Embodiment

A preferred embodiment of the present invention will be described below with reference to the accompanying drawings.

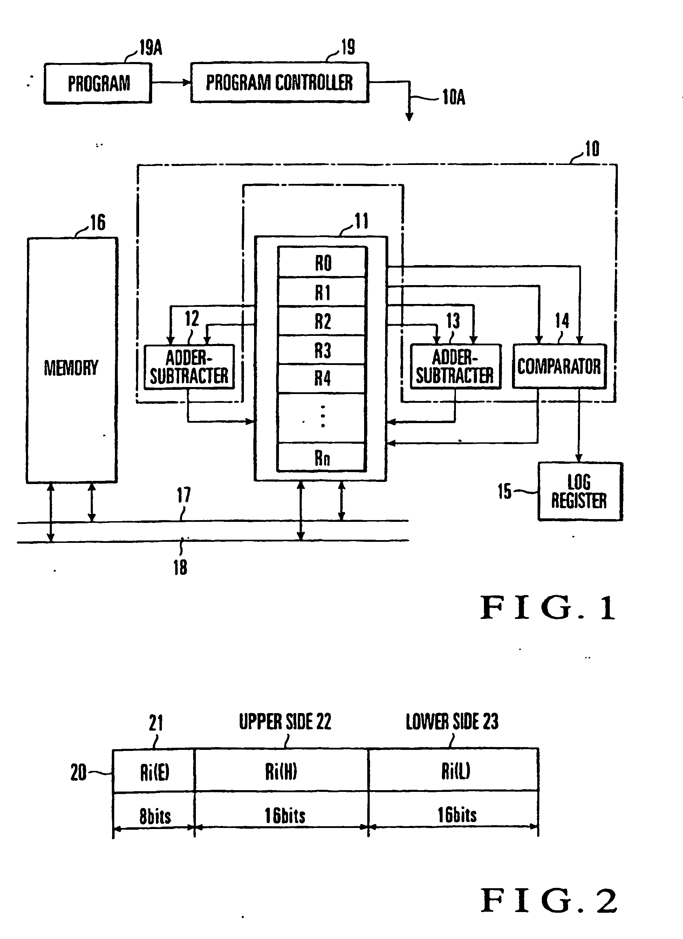

Fig. 1 is a block diagram showing a Viterbi decoding processor according to the embodiment of the present invention. The Viterbi decoding processor comprises an arithmetic means 10, a register file 11, a log register 15, a memory 16, data buses 17 and 18, and a program controller 19. The arithmetic means 10 comprises two adders-subtracters 12 and 13 and a comparator 14.

The register file 11 has a plurality of registers for temporarily storing operands (locations where input data are stored) input to an arithmetic unit, and arithmetic results from the arithmetic means 10. Fig. 2 shows an arrangement of the register. In this example, one register 20 has a 40-bit width. Upper eight bits (21) are a head room used as the accumulator of a product-sum unit, and are represented by Ri(E). The remaining 32 bits can be used to store an operand input to the arithmetic means 10 or an arithmetic result, or can be used as 16-bit registers (22 and 23) by dividing the 32 bits into an upper-16-bit Ri(H) corresponding to the upper side and a lower-16-bit Ri(L) corresponding to the lower side. In this case, the register has 40 bits, the head room has 8 bits, and the upper and lower sides have 16 bits each. However, the number of bits is not particularly limited to them.

Each of the adders-subtracters 12 and 13 uses two registers Ri and Rj as operands, and can perform parallel addition-subtraction for the upper-side Ri(H) and Rj(H) and lower-side Ri(L) and Rj(L). The sum and difference are respectively stored in the upper-side Rk(H) and lower-side Rk(L) of a register Rk.

The comparator 14 uses two registers Ri and Rj as input operands, and parallel-performs two comparison calculations. At the same time, the comparator 14 stores two bits representing the results of the two comparison calculations in the log register 15. Fig. 3 shows in more detail the functions of the comparator 14 and log register 15. The magnitudes of the upper-side Ri(H) and lower-side Ri(L) of a register Ri (31) are compared by a comparator 33, and a larger or smaller value is stored in the upper-side Rk(H) of a register Rk (35) in accordance with an instruction. At the same time, the magnitudes of the upper-side Rj(H) and lower-side Rj(L) of a register Rj (32) as the second operand are compared by a comparator 34, and a larger or smaller value is stored in the lower-side Rk(L) of the register Rk in accordance with an instruction. The comparators 33 and 34 each output one bit representing the arithmetic result. The log register 15 is made up of a register 36 with a fixed number of bits. The contents of the register 36 are shifted right by two bits, and the two bits output from the comparators 33 and 34 are simultaneously stored in the upper two bits of the register 36 in the log register 15.

The memory 16 stores a path metric and branch metric used in Viterbi decoding with a 1-word width, and is connected to the register file 11 via the 2-word width buses 17 and 18. With a multibank memory or dual port memory structure, the memory 16 can parallel-load/store data via the two buses 17 and 18. The buses 17 and 18 can exploit their 2-word width to simultaneously transfer 2-word data at adjacent addresses in the memory 16 and load the data to the upper and lower sides of the register Ri. To the contrary, the buses 17 and 18 can simultaneously transfer 2-word data stored on the upper and lower sides of the register Ri and store the data at adjacent addresses in the memory 16.

The program controller 19 sequentially outputs instructions 10A on the basis of a predetermined program 19A, controlling the above-described circuit units. The program controller 19 executes ACS processing and performs Viterbi decoding. When a surviving path is to be selected based on a new path metric calculated using the adders-subtracters 12 and 13, the comparator 14 switches the comparison condition (MAX/MIN) on the basis of the instruction 10A.

The operation of the embodiment will be explained. In the Viterbi decoding processor of Fig. 1, ACS processing regarding each state is executed by the following procedures every time a reception data sequence for one information bit is obtained.

The program controller 19 uses a predetermined circuit unit (not shown) to calculate a branch metric for each branch which changes from a state at immediately preceding time to a state at time of interest in a trellis diagram. The program controller 19 stores the calculated branch metric in the memory 16 in advance. The memory 16 stores, at adjacent addresses. 1-word width branch metrics for two branches which change from two states at the immediately preceding time to the same state at the time of interest in the trellis diagram. The program controller 19 outputs the instruction 10A to each circuit unit in Fig. 1, and sequentially performs ACS processing for the respective states at the time of interest to select surviving paths.

This embodiment gives attention to two states at the time of interest at adjacent positions in a trellis diagram, and ACS processing is efficiently performed using the commonality of ACS processing for these two states. ACS processing for two states $Sc(t+1)$ and $Sc+1(t+1)$ adjacent to each other at time $t+1$ in the trellis diagram will be explained with reference to Fig. 4.

Branch metrics bm and -bm for two branches from the states $Sa(t)$ and $Sb(t)$ which change to the state $Sc(t+1)$ are stored in advance at adjacent addresses in the memory 16 in the above-described manner. The register file 11 simultaneously reads out the branch metrics bm and -bm from the memory 16, and stores them on the upper and lower sides of the register R0 (fourth register) of the register file 11 via the 2-word width bus 17 or 18. The register file 11 reads out path metric values $pm(a)$ and $pm(b)$ from the memory 16, and stores them on the upper and lower sides of the register R1 (fifth register) via the bus 17 or 18. Note that $pm(a)$ and $pm(b)$ are not stored at adjacent addresses in the memory 16 and separately read out because $Sa(t)$ and $Sb(t)$ are not always adjacent to each other.

The adder-subtracter 12 executes parallel-addition of the registers R0 and R1, and respectively stores $pm(a)+bm$ and $pm(b)-bm$ on the upper and lower sides of the register R2 (first register). The adder-subtracter 13 executes parallel-subtraction of the registers R0 and R1, and respectively stores $pm(a)-bm$ and $pm(b)+bm$ on the upper and lower sides of the register R3 (second register). The comparator 14 compares the upper and lower sides of the register R2 and the upper and lower sides of the register R3, stores larger values on the upper and lower sides of the register R4 (third register), and stores two bits representing the comparison results in the log register 15. At this time, the value stored on the upper side of the register R4 is equal to $pm'(c)$ in equation (1), and the value stored on the lower side of the register R4 is equal to $pm'(c+1)$ in equation (2). The two bits stored in the log register 15 are used in traceback processing for final decoding using one surviving path which survives finally. New path metrics $pm'(c)$ and $pm'(c+1)$ for the states $Sc(t+1)$ and $Sc+1(t+1)$ adjacent to each other in the trellis diagram are read out from the upper and lower sides of the register R4, and simultaneously stored at adjacent addresses in the memory 16.

In this fashion, the two registers R2 (first register) and R3 (second register) are used as input operands. The upper and lower sides of the register R2 are compared, and a value selected in accordance with the comparison result is stored on the upper side of the register R4 (third register). The upper and lower sides of the register R3 are compared, and a value selected in accordance with the comparison result is stored on the lower side of the register R4. Data on the upper and lower sides of the register R4 are simultaneously read out, and stored at adjacent addresses in the memory 16 via the 2-word width bus 17 or 18. Only one memory store operation is sufficient, and ACS processing can be efficiently executed, compared to the prior art in which two new path metrics which are selected by two comparators and stored in different registers are separately stored in the memory. ACS processing can be efficiently performed without increasing the operation speed or using complicated processing.

In general, when ACS processing is to be performed using a trellis diagram, processing sequentially progresses on the basis of the positional relationship between states in the trellis diagram in order to efficiently execute program processing. As described above, two new path metrics obtained by ACS processing are stored at successive addresses in the memory 16 in accordance with the positional relationship in the trellis diagram. This improves matching between the program, i.e., software resource and the hardware resource. Program processing can be efficiently executed, and the work burden on program development can be reduced.

One-word width branch metrics for two branches which change from arbitrary states at immediately preceding time to two new states at the time of interest in the trellis diagram are respectively stored at adjacent addresses in the memory 16. In ACS processing, these two branch metrics are simultaneously read out via the 2-word width bus 17 or 18, and loaded to the upper and lower sides of the register R1 (fifth register). Only one memory load operation is required, and ACS processing can be efficiently executed in comparison with the prior art in which two branch metrics are separately loaded from the memory.

ACS processing can be executed by a total of three load operations including path metric load operation and one store operation. The cycle necessary for operation can be reduced to about 2/3 in simple comparison with the prior art in which four load operations and two store operations are performed.

This embodiment employs the two 2-word width buses 17 and 18, and allows parallel-executing the above-mentioned load operation and store operation between the memory 16 and the register file 11 via these two buses. This embodiment realizes pipeline processing, enables executing ACS processing for two states in two cycles on average, and can reduce the cycle necessary for operation to about 1/3, compared to the prior art.

The log register 15 simultaneously stores two bits representing the comparison results of two comparison calculations executed by the comparator 14. The number of log registers can be reduced to simplify the circuit arrangement, compared to the prior art in which comparison results from two comparators are stored bit by bit in different log registers.

The comparator 14 selects a larger or smaller value from two compared values in accordance with the instruction 10A from the program controller 19. The selection criterion can be easily switched in accordance with the purpose.

The adders-subtracters 52 and 53 are arranged. The adder-subtracter 52 uses the two registers R0 (fourth register) and R1 (fifth register) as input operands, and parallel-executes the first addition using values on the upper sides of the registers R0 and R1 and the second addition using values on the lower sides of the registers R0 and R1. The adder-subtracter 52 stores the first addition result on the upper side of the register R2 (first register) and the second addition result on the lower side of the register R2. The adder-subtracter 53 parallel-executes the first subtraction using values on the upper sides of the registers R0 and R1 and the second subtraction using values on the lower sides of the registers R0 and R1. The adder-subtracter 53 stores the first subtraction result on the upper side of the register R3 (second register) and the second subtraction result on the lower side of the register R3. Addition-subtraction processing for two states can be efficiently parallel-performed.

The present invention is not limited to the above embodiment, and can be properly modified within the technical scope of the present invention.

As has been described above, the present invention adopts 2-word width data buses, and a comparator which uses two predetermined registers as input operands, compares values on the upper and lower sides of the first register, stores a value selected in accordance with the comparison result on the upper side of the third register out of registers, compares values on the upper and lower sides of the second register, and stores a value selected in accordance with the comparison result on the lower side of the third register. The comparator simultaneously reads out 2-word width data stored on the upper and lower sides of the third register, and stores them at adjacent addresses in the memory via the read data bus. Only one memory store operation is sufficient, and ACS processing can be efficiently executed, compared to the prior art in which two new path metrics which are selected by two comparators and stored in different registers are separately stored in the memory. ACS processing can be efficiently performed without increasing the operation speed or using complicated processing.

## Claims

1. A Viterbi decoding processor comprising a 1-word width memory (16) arranged to store a path metric and a branch metric that appear in Viterbi decoding, a register file (11) having a plurality of 2-word width registers at arranged to temporarily store 1-word width data on upper and lower sides, and arithmetic means arranged to calculate a new path metric on the basis of a predetermined arithmetic expression using the path metric and the branch metric which are loaded from said memory to an arbitrary register of said register file via a bus,
**characterized in that** said arithmetic means comprises a comparator arranged to use, of the registers, two predetermined registers as input operands, to compare values on the upper and lower sides of a first register (31) as one of the two registers, to store a value selected in accordance with a comparison result on the upper side of a third register (35) out of the registers, to compare values on the upper and lower sides of a second register as the other register, and to store a value selected in accordance with a comparison result on the lower side of the third register, the bus is formed from a 2-word width data bus, and
said register file is arranged to simultaneously read out 2-word width data stored on the upper and lower sides of the third register and to store the 2-word width data at adjacent addresses in said memory via the data bus.

2. A Viterbi decoding processor according to claim 1, **characterized by** further comprising a log register arranged to simultaneously store two bits representing comparison results of two comparison calculations executed by the comparator.

3. A Viterbi decoding processor according to claim 1, **characterized in that** the comparator is arranged to select a larger or smaller value of the two values in accordance with a predetermined instruction in comparison calculation.

4. A Viterbi decoding processor according to claim 1, **characterized in that** said arithmetic means further comprises a first adder-subtracter (12) arranged to use, of the registers, two predetermined registers as input operands, to parallel-execute a first addition using a value on the upper side of a fourth register as one of the two registers and a value on the upper side of a fifth register as the other register and a second addition using values on the lower sides of the fourth and fifth registers, to store a result of the first addition on the upper side of the first register and a result of the second addition on the lower side of the first register, and a second adder-subtracter (13) which is arranged to the fourth and fifth registers as input operands, to parallel-execute a first subtraction using the values on the upper sides of the fourth and fifth registers and a second subtraction using the values on the lower sides of the fourth and fifth registers, to store a result of the first subtraction on the upper side of the second register and a result of the second subtraction on the lower side of the second register.

5. A Viterbi decoding processor according to claim 4, **characterized in that**

said memory is arranged to store, at adjacent addresses, 1-word width branch metrics for two branches which change from two states at immediately preceding time to one state at time of interest in a trellis diagram, and said register file is arranged to simultaneously read out the two branch metrics stored in said memory via the data bus and loads the two branch metrics to the upper and lower sides of the fifth register.

6.  A Viterbi decoding processor according to claim 5, **characterized in that**
    the bus includes two 2-word width data buses, and
    said register file is arranged to parallel-execute, individually using the two data buses, two operations out of simultaneous load of the two branch metrics from said memory to the fifth register, individual load of each path metric from said memory to the fourth register, and simultaneous store of two new path metrics from the third register to said memory.

## Patentansprüche

1.  Viterbi-Decodierungsprozessor mit:

    einem 1-Wort breiten Speicher (16), der dazu geeignet ist, eine Pfadmetrik und eine Zweigmetrik zu speichern, die bei einer Viterbi-Decodierung auftreten;
    einer Registerdatei (11) mit mehreren 2-Wort breiten Registern, die dazu geeignet sind, 1-Wort breite Daten an einer höheren und einer niedrigeren Seite zwischenzuspeichern; und
    einer Arithmetikeinrichtung, die dazu geeignet ist, eine neue Pfadmetrik auf der Basis eines vorgegebenen arithmetischen Ausdrucks unter Verwendung der Pfadmetrik und der Zweigmetrik zu berechnen, die vom Speicher über einen Bus in ein beliebiges Register der Registerdatei geladen werden;
    **dadurch gekennzeichnet, dass**
    die Arithmetikeinrichtung einen Vergleicher aufweist, der dazu geeignet ist, unter den Registern zwei vorgegebene Register für Eingangsoperanden zu verwenden, um Werte an der höheren und der niedrigeren Seite eines ersten Registers (31) als eines der beiden Register zu vergleichen, einen gemäß dem Vergleichsergebnis ausgewählten Wert an der höheren Seite eines dritten Registers (35) unter den Registern zu speichern, Werte an der höheren und der niedrigeren Seite eines zweiten Registers als das andere Register zu vergleichen und einen gemäß einem Vergleichsergebnis ausgewählten Wert an der niedrigeren Seite des dritten Registers zu speichern;
    der Bus ein 2-Wort breiter Datenbus ist; und
    die Registerdatei dazu geeignet ist, über den Datenbus an der höheren und der niedrigeren Seite des dritten Registers gespeicherte 2-Wort breite Daten gleichzeitig auszulesen und die 2-Wort breiten Daten an benachbarten Adressen im Speicher zu speichern.

2.  Viterbi-Decodierungsprozessor nach Anspruch 1, ferner mit einem Log-Register, das dazu geeignet ist, zwei Bits gleichzeitig zu speichern, die Vergleichsergebnisse von zwei durch den Vergleicher ausgeführten Vergleichsoperationen darstellen.

3.  Viterbi-Decodierungsprozessor nach Anspruch 1, **dadurch gekennzeichnet, dass** der Vergleicher dazu geeignet ist, in der Vergleichsoperation gemäß einem vorgegebenen Befehl einen größeren oder einen kleineren Wert der beiden Werte auszuwählen.

4.  Viterbi-Decodierungsprozessor nach Anspruch 1, **dadurch gekennzeichnet, dass** die Arithmetikeinrichtung ferner aufweist:

    einen ersten Addierer/Subtrahierer (12), der dazu geeignet ist, unter den Register zwei vorgegebene Register für Eingangsoperanden zu verwenden, um eine erste Additionsoperation unter Verwendung eines Wertes an der höheren Seite eines vierten Registers als eines der beiden Register und eines Wertes an der höheren Seite eines fünften Registers als das andere Register und eine zweite Additionsoperation unter Verwendung von Werten an den niedrigeren Seiten des vierten und des fünften Registers parallel auszuführen, um ein Ergebnis der ersten Additionsoperation an der höheren Seite des ersten Registers und ein Ergebnis der zweiten Additionsoperation an der niedrigeren Seite des ersten Registers zu speichern; und
    einen zweiten Addierer/Subtrahierer (13), der dazu geeignet ist, das vierte und das fünfte Register für Eingangsoperanden zu verwenden, um eine erste Subtraktionsoperation unter Verwendung der Werte an der höheren Seite des vierten und des fünften Registers und eine zweite Subtraktionsoperation unter Verwendung der Werte an den niedrigeren Seiten des vierten und des fünften Registers parallel auszuführen, um ein Ergebnis der ersten Subtraktionsoperation an der höheren Seite des zweiten Registers und ein Ergebnis der zweiten Subtraktionsoperation an der niedrigeren Seite des zweiten Registers zu speichern.

5. Viterbi-Decodierungsprozessor nach Anspruch 4, **dadurch gekennzeichnet, dass**
der Speicher dazu geeignet ist, 1-Wort breite Zweigmetriken für zwei Zweige, die sich in einem Trellis-Diagramm von zwei Zuständen zu einem unmittelbar vorangehenden Zeitpunkt auf einen Zustand zu einem Zeitpunkt von Interesse ändern, an benachbarten Adressen zu speichern; und
die Registerdatei dazu geeignet ist, die im Speicher gespeicherten beiden Zweigmetriken über den Datenbus gleichzeitig auszulesen und die beiden Zweigmetriken zur höheren und zur niedrigeren Seite des fünften Registers zu laden.

6. Viterbi-Decodierungsprozessor nach Anspruch 5, **dadurch gekennzeichnet, dass**
der Bus zwei 2-Wort breite Datenbusse aufweist; und
die Registerdatei dazu geeignet ist, unter individueller Verwendung der beiden Datenbusse zwei Operationen unter den folgenden Operationen gleichzeitig auszuführen: i) gleichzeitiges Laden der beiden Zweigmetriken vom Speicher zum fünften Register, ii) individuelles Laden jeder Pfadmetrik vom Speicher zum vierten Register, und iii) gleichzeitiges Speichern zweier neuer Pfadmetriken vom dritten Register in den Speicher.

## Revendications

1. Processeur de décodage de Viterbi comprenant une mémoire d'un mot de large (16) arrangée pour stocker une métrique de chemin et une métrique de branche qui apparaissent dans le décodage de Viterbi, un fichier de registre (11) ayant une pluralité de registres de deux mots de large arrangés pour stocker de manière temporaire des données d'un mot de large sur les côtés supérieur et inférieur, et des moyens arithmétiques arrangés pour calculer une nouvelle métrique de chemin sur la base d'une expression arithmétique prédéterminée à l'aide de la métrique de chemin et de la métrique de branche qui sont chargées à partir de ladite mémoire dans un registre arbitraire dudit fichier de registre via un bus,
**caractérisé en ce que** lesdits moyens arithmétiques comprennent un comparateur arrangé pour utiliser, parmi les registres, deux registres prédéterminés comme opérandes d'entrée, pour comparer des valeurs sur les côtés supérieur et inférieur d'un premier registre (31) en tant qu'un des deux registres, pour stocker une valeur sélectionnée en accord avec un résultat de comparaison sur le côté supérieur d'un troisième registre (35) n'étant aucun des deux registres, pour comparer des valeurs sur les côtés supérieur et inférieur d'un second registre en tant que l'autre registre, et pour stocker une valeur sélectionnée en accord avec un résultat de comparaison sur le côté inférieur du troisième registre,
le bus est formé à partir d'un bus de données de deux mots de large, et
ledit fichier de registre est arrangé pour simultanément extraire de la mémoire des données de deux mots de large stockées sur les côtés supérieur et inférieur du troisième registre et pour stocker les données de deux mots de large à des adresses adjacentes dans ladite mémoire, via le bus de données.

2. Processeur de décodage de Viterbi selon la revendication 1, **caractérisé en ce qu'**il comprend en outre un registre journal arrangé pour simultanément stocker deux bits représentant des résultats de comparaison de deux calculs de comparaison exécutés par le comparateur.

3. Processeur de décodage de Viterbi selon la revendication 1, **caractérisé en ce que** le comparateur est arrangé pour sélectionner la valeur la plus grande ou la plus petite des deux valeurs en accord avec une instruction prédéterminée dans le calcul de comparaison.

4. Processeur de décodage de Viterbi selon la revendication 1, **caractérisé en ce que** lesdits moyens arithmétiques comprennent en outre un premier additionneur soustracteur (12) arrangé pour utiliser, parmi les registres, deux registres prédéterminés comme opérandes d'entrée, pour exécuter en parallèle une première addition à l'aide d'une valeur du côté supérieur d'un quatrième registre, en tant qu'un des deux registres, et une valeur du côté supérieur d'un cinquième registre, en tant que l'autre registre, et une seconde addition à l'aide des valeurs sur les côtés inférieurs du quatrième et du cinquième registres, pour stocker un résultat de la première addition sur le côté supérieur du premier registre et un résultat de la seconde addition sur le côté inférieur du premier registre, et un second additionneur soustracteur (13) qui est arrangé pour utiliser le quatrième et le cinquième registres comme opérandes d'entrée, pour exécuter en parallèle une première soustraction à l'aide des valeurs sur les côtés supérieurs des quatrième et cinquième registres et une seconde soustraction à l'aide des valeurs sur les côtés inférieurs des quatrième et cinquième registres, pour stocker un résultat de la première soustraction sur le côté supérieur du second registre et un résultat de la seconde soustraction sur le côté inférieur du second registre.

5.  Processeur de décodage de Viterbi selon la revendication 4, **caractérisé en ce que** :

   ladite mémoire est arrangée pour stocker, à des adresses adjacentes, des métriques de branche d'un mot de large pour deux branches qui changent de deux états, à un temps immédiatement précédent, à un état au temps d'intérêt dans un diagramme en treillis, et
   ledit fichier de registre est arrangé pour simultanément extraire de la mémoire les deux métriques de branche stockées dans ladite mémoire via le bus de données et pour charger les deux métriques de branche sur les côtés supérieur et inférieur du cinquième registre.

6.  Processeur de décodage de Viterbi selon la revendication 5, **caractérisé en ce que** :

   le bus comprend deux bus de données de deux mots de large, et
   ledit fichier de registre est arrangé pour exécuter en parallèle, en utilisant individuellement les deux bus de données, deux opérations parmi le chargement simultané des deux métriques de branche depuis ladite mémoire vers le cinquième registre, le chargement individuel de chaque métrique de chemin depuis ladite mémoire vers le quatrième registre, et le stockage simultané de deux nouvelles métriques de chemin depuis le troisième registre vers ladite mémoire.

FIG.1

FIG.2

| Ri(E) | Ri(H) | Ri(L) |
|---|---|---|

31

| Rj(E) | Rj(H) | Rj(L) |
|---|---|---|

32

14

INSTRUCTION

10A

MAX/MIN.   33

MAX/MIN.   34

| Rk(E) | Rk(H) | Rk(L) |
|---|---|---|

35

36

15

## FIG.3

PATH METRIC pm(a)

STATE Sa(t)

PATH METRIC pm'(c)

STATE Sc(t+1)

bm

-bm

-bm

PATH METRIC pm'(c+1)

STATE Sc+1(t+1)

PATH METRIC pm(b)

STATE Sb(t)

bm

TIME t

TIME t+1

## FIG.4

FIG. 5

EP 1 355 431 B1